# FASCICULE DE BREVET EUROPEEN

(11) **EP 2 212 925 B1**
(45) Date de publication et mention de la délivrance du brevet: **28.08.2019**
(21) Numéro de dépôt: 08840273.0
(22) Date de dépôt: 13.10.2008
(51) Int. Cl.: H01L 31/048, H01L 31/18, H01L 31/02, H01L 31/042

(54) **PERFECTIONNEMENTS APPORTÉS À DES JOINTS POUR DES ÉLÉMENTS CAPABLES DE COLLECTER DE LA LUMIÈRE**
VERBESSERUNGEN AN DICHTUNGEN FÜR LICHTERFASSUNGSELEMENTE
IMPROVEMENTS MADE TO SEALS FOR LIGHT-CAPTURING ELEMENTS

(30) Priorité: 16.10.2007 FR 0758352
(43) Date de publication de la demande: 04.08.2010
(73) Titulaire: (CNBM) Bengbu Design & Research Institute for Glass Industry Co., Ltd., Bengbu (CN)
(72) Inventeur: PROBST, Volker, 14089 Berlin (DE); KUSTER, Hans-Werner, 52066 Aachen (DE); MAURER, Marc, 60350 Saint Jean aux Bois (FR); CALWER, Hermann, 81241 München (DE)
(74) Mandataire: Gebauer, Dieter Edmund
(86) Numéro de dépôt international: PCT/EP2008/063746
(87) Numéro de publication internationale: WO 2009/050146

(56) Documents cités:
- DE-A1- 3 544 080
- US-A- 4 249 958
- US-A- 5 478 402
- US-A- 5 733 382
- US-A1- 2007 144 576
- US-B2- 6 420 646

## Description

La présente invention est relative à des perfectionnements apportés à des éléments capables de collecter de la lumière.

Il est connu que des éléments capables de collecter de la lumière du type cellules solaires photovoltaïques comportent un agent absorbant, et deux électrodes sur n'importe quelle face. L'ensemble est encapsulé entre deux substrats dont l'un constitue un substrat de protection à fonction verrière afin de permettre le passage de la lumière et l'autre substrat forme un support et n'est donc pas nécessairement transparent. Ces électrodes se caractérisent essentiellement par une résistance électrique de surface aussi faible que possible et une bonne adhérence à la couche d'absorbeur ainsi que le cas échéant au substrat. Les électrodes sont la plupart du temps fabriquées en métal ou à partir d'un oxyde métallique, par exemple à base de molybdène, d'argent, d'aluminium, de cuivre, d'oxyde de zinc dopé, ou d'oxyde d'étain.

Les composés ternaires chalcopyrites qui peuvent jouer le rôle d'absorbeur contiennent généralement du cuivre, de l'indium et du sélénium. Il s'agit là de ce que l'on appelle des couches d'agent absorbant CISe₂. On peut aussi ajouter à la couche d'agent absorbant du gallium (ex : Cu(In,Ga)Se₂ ou CuGaSe₂), de l'aluminium (ex : Cu(In,Al)Se₂), ou du soufre (ex : CuIn(Se,S). On les désigne en général et ci-après par le terme de couches d'agent absorbant à chalcopyrite.

Une autre famille d'agent absorbant, en couche mince, est soit à base de silicium, ce dernier pouvant être amorphe ou microcristallin, soit à base de tellure de cadmium (CdTe). Il existe également une autre famille d'agent absorbant à base de wafers de silicium polycristallin, déposé en couche épaisse, avec une épaisseur comprise entre 50 µm à 250 µm, au contraire de la filière silicium amorphe ou microcristallin, qui est déposé en couche mince.

Pour ces agents absorbants de diverses technologies, on sait que leur rendement photovoltaïque (de conversion énergétique) est réduit de manière notable lors de la pénétration d'humidité, par diffusion de molécules d'eau sous forme liquide et/ou vapeur, même sans une détérioration visible de l'aspect optique.

C'est pourquoi l'assemblage des cellules solaires qui consiste à réunir entre 2 substrats, l'ensemble des couches et des connexions électriques permettant de relier ladite cellule à l'extérieur pour une utilisation de l'énergie produite, doit être réalisé avec le plus grand soin en veillant particulièrement à étanchéifier la cellule solaire. Particulièrement cette étanchéité de la cellule est réalisée au niveau d'une part, du chant de la cellule par le dépôt par exemple par une technique d'extrusion d'un cordon de joint et au niveau d'autre part, des orifices de passage des connexions électriques.

Le document US5478402 décrit une méthode de fabrication d'un module solaire.ü

Comme on l'a vu précédemment, la couche d'agent absorbant et les électrodes sont sensibles à l'humidité et l'assemblage de la cellule solaire doit veiller à empêcher toute pénétration d'humidité. Les constructeurs de cellule solaire ont développé en collaboration avec des spécialistes de la chimie des compositions pour joint (ou pour un ensemble de joints, un joint étant destiné par exemple à exercer une barrière à l'eau liquide, et autre joint réalisant une barrière à l'eau vapeur) qui remplissent leur fonction en périphérie de la cellule.

Bien que l'assemblage soit réalisé avec le plus grand soin possible, des risques de pénétration d'humidité sous forme liquide et/ou vapeur au niveau de la périphérie du module demeurent encore et peuvent entraîner à terme une baisse de performance du module.

La présente invention vise à pallier ces inconvénients en proposant un procédé d'étanchéification des modules qui limite, voire supprime toute diffusion d'humidité au travers du module.

A cet effet, le procédé d'étanchéification d'un élément capable de collecter de la lumière, ledit élément comportant un premier substrat à fonction verrière, formant couvercle, et un second substrat, lesdits substrats emprisonnant à l'aide d'un intercalaire de feuilletage un empilement actif de couches comprenant des couches conductrices formant électrodes et au moins une couche fonctionnelle à base d'un matériau absorbeur permettant une conversion énergétique de la lumière en énergie électrique, ledit empilement étant déposé sur au moins une portion de surface de l'un au moins des substrats de manière à délimiter en périphérie une gorge adaptée pour recevoir au moins un moyen d'étanchéification dudit module, se caractérise en ce qu'on dépose le moyen d'étanchéification dans la gorge avant la phase d'autoclave.

En réalisant le remplissage de la gorge, à pression ambiante, par exemple atmosphérique, par extrusion d'un cordon de joint avant la phase de passage en autoclave, on évite que les solvants initialement contenus dans l'intercalaire de feuilletage ne viennent polluer les parois de la gorge, ces pollutions étant des chemins pour la diffusion de l'humidité.

Dans des modes de réalisation préférés de l'invention, on peut éventuellement avoir recours en outre à l'une et/ou à l'autre des dispositions suivantes :
- La gorge est remplie au moins en partie par un premier moyen d'étanchéification, notamment vis-à-vis de l'eau sous forme vapeur, le moyen d'étanchéification comprenant au moins un joint à base de polymère(s) thermofusible(s) choisi(s) parmi au moins une des familles de polymère suivantes : étylène-vinylacétate, polyisobutylène,, butyle, polyamide, ou à base d'un mastic, notamment à base de polyuréthane, polysulfure ou silicone,
- le(s) joint(s) du premier moyen d'étanchéification périphérique présente(nt) une viscosité comprise entre 0,1 et 20 Pa.s, notamment comprise entre 0,8 et 15 Pa.s à 190°C.
- le(s) joint(s) du premier moyen d'étanchéification périphérique présente(nt) un point de ramollissement compris entre 150 et 250°C, et préférentiellement compris entre 180 et 220°C,
- le(s) joint(s) du premier moyen d'étanchéification périphérique présente(nt) une perméabilité à l'eau sous forme vapeur inférieure ou égale à 1 g/m²/24h, préférentiellement inférieure à 0.5 g/m²/24h, de manière encore plus préférée inférieure à 0.26 g/m²/24h selon la norme ASTM E 9663 T.
- le(s) joint(s) du premier moyen d'étanchéification périphérique est (sont) posé(s) par extrusion ou injection en phase liquide.
- le(s) joint(s) du premier moyen d'étanchéification périphérique présente(nt) une température d'extrusion ou d'injection supérieure à la température de fusion de l'intercalaire de feuilletage,
- on rapporte après la phase d'autoclave un second moyen d'étanchéification périphérique, sous forme d'au moins un joint étanche vis-à-vis de l'eau liquide, notamment choisi à base de polyuréthane, de silicone, de polysulfure.
- on rapporte avant la phase d'autoclave un second moyen d'étanchéification périphérique, sous forme d'au moins un joint étanche vis-à-vis de l'eau liquide, notamment choisi à base de polyuréthane, de silicone, de polysulfure.
- Le second moyen d'étanchéification périphérique est formé d'un joint en polymère du type EPDM,
- Le second moyen d'étanchéification périphérique se présente sous la forme d'un anneau,
- Le second moyen d'étanchéification est rapporté par collage, par emboitage au sein de ladite gorge,
- le second moyen d'étanchéification est rapporté de manière affleurante au sein d'une zone en retrait périphérique, cette zone étant venue lors de l'assemblage de deux substrats, l'un étant de dimension inférieure à l'autre.

Selon un autre aspect ne faisant pas partie de l'invention il est décrit un élément capable de collecter de la lumière obtenu selon le procédé d'étanchéification précédemment décrit et qui comporte un premier substrat à fonction verrière et un second substrat, lesdits substrats emprisonnant à l'aide d'un intercalaire de feuilletage un empilement actif de couches comprenant des couches conductrices formant électrodes et au moins une couche fonctionnelle à base d'un matériau absorbeur permettant une conversion énergétique de la lumière en énergie électrique, ledit empilement étant déposé sur au moins une portion de surface de l'un au moins des substrats de manière à délimiter en périphérie une gorge, cet élément se caractérise en ce que la gorge est remplie au moins en partie d'au moins un moyen d'étanchéification à l'eau en phase en liquide et vapeur.

D'autres caractéristiques, détails, avantages de la présente invention apparaîtront mieux à la lecture de la description qui va suivre, faite à titre illustratif et nullement limitatif, en référence à des figures annexées sur lesquelles :
- les figures 1a et 1b sont des vues schématiques d'un élément capable de collecter de la lumière,
- la figure 2 est une vue en perspective et à plus grande échelle, d'une zone située en périphérie de l'élément représenté en figure la, et plus précisément au niveau de la gorge périphérique,
- la figure 3 est une vue en perspective et à plus grande échelle, d'une zone située en périphérie de l'élément représenté en figure 1b et plus précisément au niveau de la gorge périphérique,
- la figure 4 est une vue en perspective et à plus grande échelle, d'une zone située en périphérie de l'élément représenté en figure la et plus précisément au niveau de la gorge périphérique,

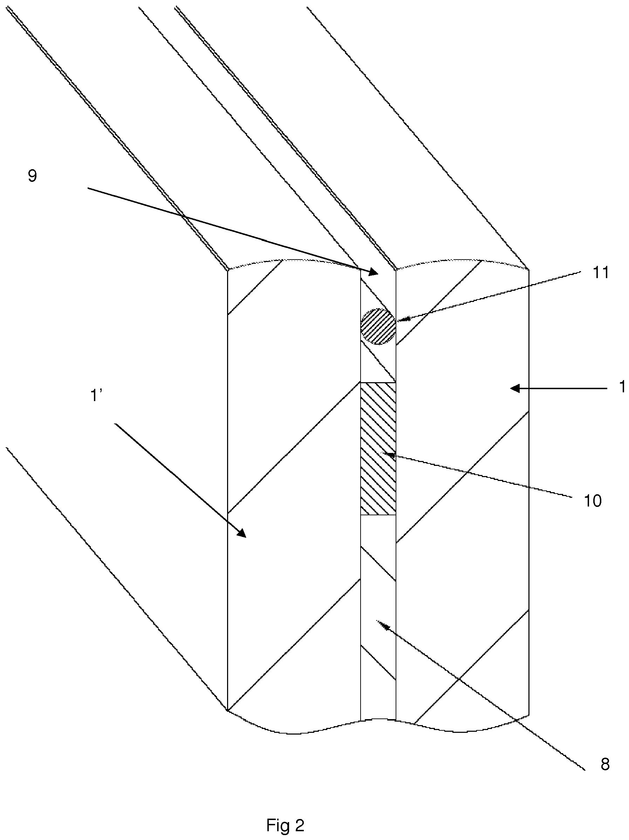

Sur la figure la, on a représenté un élément capable de collecter de la lumière (une cellule ou un module solaire ou photovoltaïque). La gorge présente en périphérie est dépourvue des moyens d'étanchéification représentés à plus grande échelle en figures 2, 3, 4.

Le substrat 1 transparent à fonction verrière, formant couvercle, peut par exemple être entièrement en verre. Il peut également être en un polymère thermoplastique tel qu'un polyuréthane ou un polycarbonate ou un polyméthacrylate de méthyle.

L'essentiel de la masse (c'est-à-dire pour au moins 98 % en masse), voire la totalité du substrat à fonction verrière est constituée de matériau(x) présentant la meilleure transparence possible et ayant de préférence une absorption linéique inférieure à 0,01 mm⁻¹ dans la partie du spectre utile à l'application (module solaire), généralement le spectre allant de 380 à 1200 nm.

Le substrat 1 formant couvercle, selon l'invention peut avoir une épaisseur totale allant de 0,5 à 10 mm lorsqu'on l'utilise comme plaque protectrice d'une cellule photovoltaïque de diverses technologies (CIS, silicium amorphe, silicium micro cristallin par exemple). Dans ce cas, il peut être avantageux de faire subir à cette plaque un traitement thermique (du type trempe par exemple) lorsqu'il est en verre.

De manière conventionnelle, on définit par A la face avant du substrat dirigée vers les rayons lumineux (il s'agit de la face externe), et par B la face arrière du substrat dirigée vers le reste des couches du module solaire (il s'agit de la face interne).

De manière conventionnelle, on définit par A la face avant du substrat dirigée vers les rayons lumineux (il s'agit de la face externe), et par B la face arrière du substrat dirigée vers le reste des couches du module solaire (il s'agit de la face interne).

La face B du substrat 1' (formant support) est revêtue d'une couche première couche conductrice 2 devant servir d'électrode. Sur cette électrode 2 est déposée la couche fonctionnelle 3 à base d'agent absorbant à chalcopyrite. Lorsqu'il s'agit d'une couche fonctionnelle 3 à base par exemple de CIS, CIGS, ou CIGSe₂ il est préférable que l'interface entre la couche fonctionnelle 3 et l'électrode 2 soit à base de molybdène. Une couche conductrice répondant à ces exigences est décrite dans la demande de brevet européen EP1356528.

La couche d'agent absorbant à chalcopyrite 3 est revêtue d'une fine couche 4, formant tampon, en sulfure de cadmium (CdS), ou en sulfure de zinc (ZnS), ou en sulfure d'indium (IS) permettant de créer avec la couche à chalcopyrite 3 une jonction pn. En effet, l'agent chalcopyrite est généralement dopé p, la couche 4, par exemple, en CdS étant dopée n, cela permet de créer la jonction pn nécessaire à l'établissement d'un courant électrique.

Cette fine couche 4 de CdS est elle-même recouverte d'une couche d'accrochage 5 généralement formée d'oxyde de zinc non dopé (ZnO).

Afin de former la seconde électrode, la couche 5 de ZnO est recouverte d'une couche 6 en TCO pour « Transparent Conductive Oxide ».

Afin de former la seconde électrode 6, la couche de ZnO 5 est recouverte d'une couche en TCO pour « Transparent Conductive Oxide ». Elle peut être choisie parmi les matériaux suivants : oxyde d'étain dopé, notamment en bore, ou en aluminium. Dans le cas de l'oxyde de zinc dopé, notamment à l'aluminium, les précurseurs utilisables, en cas de dépôt par CVD, peuvent être des organo-métalliques ou halogénures de zinc et d'aluminium. L'électrode en TCO, par exemple en ZnO peut être aussi déposée par pulvérisation à partir de cible métallique ou céramique.

Par ailleurs, cette couche conductrice doit être aussi transparente que possible, et présenter une transmission élevée de la lumière dans l'ensemble des longueurs d'onde correspondant au spectre d'absorption du matériau constituant la couche fonctionnelle, afin de ne pas réduire inutilement le rendement du module solaire.

La couche conductrice 6 présente résistance par carré d'au plus 30 ohms/carré, notamment d'au plus 20 ohms/carré, de préférence d'au plus 10 ou 15 ohms/carré. Elle est généralement comprise entre 5 et 12 ohms/carré.

L'empilement 7 de couches minces est emprisonné entre les substrats 1 (formant couvercle) et 1' (formant support) par l'intermédiaire d'un intercalaire de feuilletage 8 par exemple en PU, PVB ou EVA. Le substrat 1' se distingue du substrat 1 par le fait qu'il est nécessairement en verre, à base d'alcalins (pour des raisons qui ont été explicitées dans le préambule de l'invention), comme un verre silico-sodo-calcique de manière à conformer une cellule solaire ou photovoltaïque puis encapsulé périphériquement à l'aide d'un joint ou d'une résine d'étanchéité. Un exemple de composition de cette résine et de ses modalités de mise en oeuvre est décrit dans la demande EP739042.

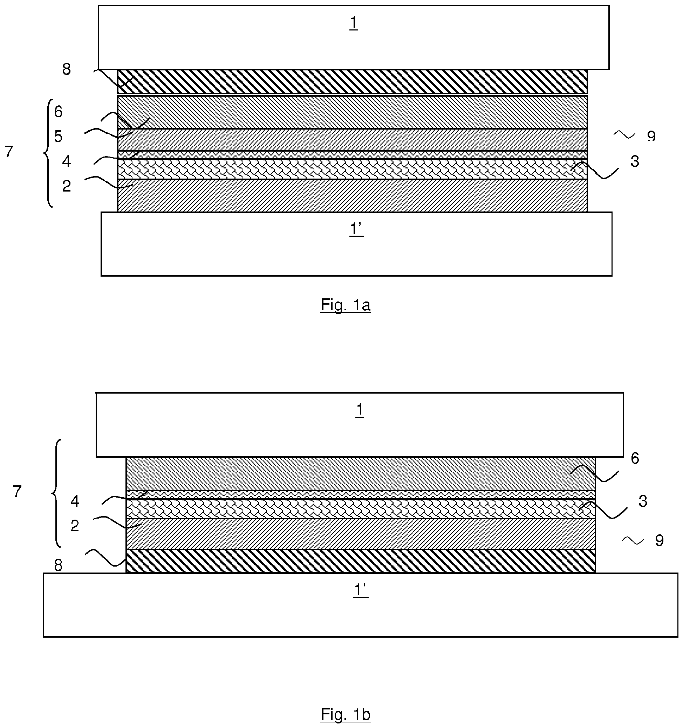

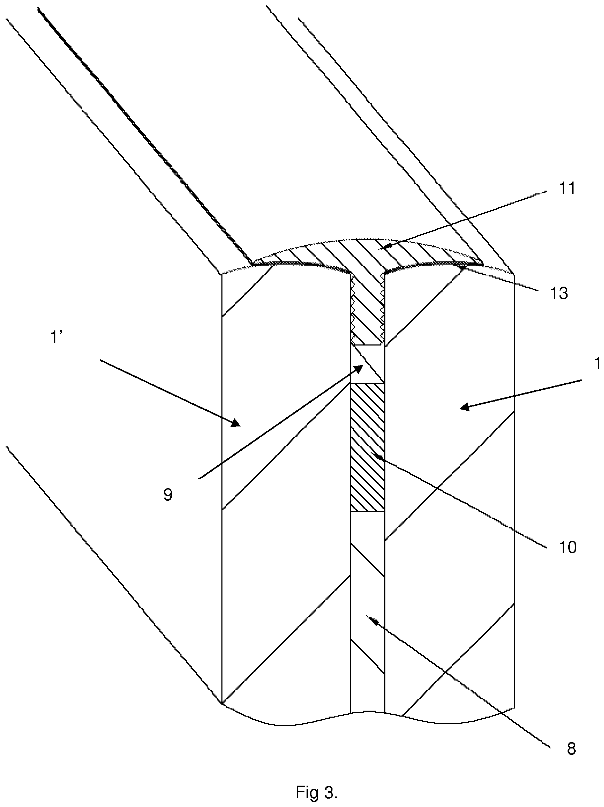

Si on utilise un agent absorbant à base de silicium comme par exemple une couche mince, à base de silicium amorphe, ou silicium micro cristallin, ou à base de tellure de cadmium, la construction de l'élément capable de collecter de la lumière est réalisée en sens inverse de celui utilisé pour la filière à chalcopyrite. On parle de construction dite à « superstrate » par opposition à la construction dite à « strate ». On pourra se reporter à la figure 1b. On remarque par ailleurs que les substrats ne sont pas nécessairement de même dimension, le substrat porteur étant de dimension supérieure par rapport au substrat de protection, de manière une zone en retrait au niveau de la gorge périphérique. Cette gorge est représentée à plus grande échelle en figure 3.

La différence essentielle réside dans le fait que l'empilement de couches minces est construit à partir du substrat 1 (formant couvercle). La face B du substrat 1 est revêtue d'une première couche conductrice 2 devant servir d'électrode. Sur cette électrode 2 est déposée la couche fonctionnelle 3 à base d'agent absorbant en silicium en couche mince ou en en tellure de cadmium.

Afin de former la seconde électrode, la couche est à base d'une couche en TCO pour « Transparent Conductive Oxide ».
Afin de former la seconde électrode 6, la couche de ZnO 5 est recouverte d'une couche en TCO pour « Transparent Conductive Oxide ».

Afin de former la seconde électrode 6, la couche de ZnO 5 est recouverte d'une couche en TCO pour « Transparent Conductive Oxide ». Elle peut être choisie parmi les matériaux suivants : oxyde d'étain dopé, notamment en bore, ou en aluminium. Dans le cas de l'oxyde de zinc dopé, notamment à l'aluminium, les précurseurs utilisables, en cas de dépôt par CVD, peuvent être des organo-métalliques ou halogénures de zinc et d'aluminium. L'électrode en TCO, par exemple en ZnO peut être aussi déposée par pulvérisation à partir de cible métallique ou céramique.

Par ailleurs, cette couche conductrice doit être aussi transparente que possible, et présenter une transmission élevée de la lumière dans l'ensemble des longueurs d'onde correspondant au spectre d'absorption du matériau constituant la couche fonctionnelle, afin de ne pas réduire inutilement le rendement du module solaire.

Cette couche de TCO, à base par exemple de SnO2 : F ou de ZnO : Al est éventuellement recouverte d'une couche additionnelle relativement mince (par exemple 100 nm) en ZnO diélectrique non dopée (ZnO). Cette couche mince de ZnO est ensuite recouverte de la couche fonctionnelle à base de silicium en couche mince. Le reste de l'empilement est constitué d'une deuxième couche conductrice servant d'électrode en matériau métallique ou d'oxyde métallique. Classiquement cette couche électrode est à base d'ITO (oxyde d'indium et d'étain) ou en métal (cuivre, aluminium)

La couche conductrice 6 présente résistance par carré d'au plus 30 ohms/carré, notamment d'au plus 20 ohms/carré, de préférence d'au plus 10 ou 15 ohms/carré. Elle est généralement comprise entre 5 et 12 ohms/carré.

L'empilement de couches minces est emprisonné entre les substrats 1 (formant couvercle) et 1' (formant support) par l'intermédiaire d'un intercalaire de feuilletage 8 par exemple en PU, PVB ou EVA. Le substrat 1' se distingue du substrat 1 par le fait qu'il n'est pas nécessairement en verre et n'est pas forcément transparent. Il joue un rôle de support et est encapsulé avec l'autre substrat 1 périphériquement à l'aide d'un joint ou d'une résine d'étanchéité. Un exemple de composition de cette résine et de ses modalités de mise en oeuvre est décrit dans la demande EP739042.

Quel que soit le mode de réalisation de l'élément capable de collecter de la lumière, ce dernier comporte en périphérie une gorge 9 (se reporter au niveau des figures 2 et 3). Cette gorge 9 est adaptée pour recevoir des moyens d'étanchéification 10, 11 devant assurer une protection de l'empilement actif à l'égard de l'eau liquide et de l'eau vapeur.

Pour ce faire, on prévoit de remplir la gorge 9, avant que l'élément capable de collecter de la lumière ne soit mis dans un autoclave - le passage en autoclave étant nécessaire pour la réalisation de la phase d'assemblage de l'élément par feuilletage - d'un premier moyen d'étanchéification 10. Le remplissage de la gorge est réalisé à pression ambiante, par exemple à pression atmosphérique, au contraire des procédés connus de l'art antérieur (US5733382, DE3544080) qui disposent que cette phase de dépôt du joint périphérique est réalisée à une pression réduite, par exemple sous vide.

En variante, la gorge 9 peut être remplie des moyens d'étanchéification avant une phase de pré-laminage.

En procédant ainsi, on évite que les solvants initialement contenus dans l'intercalaire de feuilletage ne viennent polluer les parois de la gorge, ces pollutions étant des chemins pour la diffusion de l'humidité.

Avant d'être mis dans l'autoclave, on aura ôté les bulles d'air emprisonnées au sein du vitrage par une technique traditionnelle de calandrage, ou par tirage au vide (à l'aide de poche, ou à l'aide d'un cordon périphérique, couramment appelé « snake » relié à une source de vide), ou par pré-laminage.

La gorge 9 est remplie au moins en partie, par une technique d'extrusion ou d'injection, d'un premier moyen 10 d'étanchéification constitué par un joint choisi parmi l'une des familles de polymère suivantes : étylène-vinylacétate, polyisobutylène, butyle, polyamide, ou à base d'un mastic, notamment à base de polyuréthane, polysulfure ou silicone. On choisit un joint dont la viscosité sera comprise entre 0,1 et 20 Pa.s, notamment comprise entre 0,8 et 15 Pa.s, à 190°C. Le point de ramollissement est compris entre 150 et 250°C, et préférentiellement compris entre 180 et 220°C. Le(s) joint(s) du premier moyen d'étanchéification périphérique présente(nt) une perméabilité à l'eau sous forme vapeur inférieure ou égale à 1 g/m²/24h, préférentiellement inférieure à 0.5 g/m²/24h, de manière encore plus préférée inférieure à 0.26 g/m²/24h selon la norme ASTM E 9663 T.

De plus, la température d'extrusion ou d'injection est supérieure à la température de fusion de l'intercalaire de feuilletage.

Un exemple de réalisation de ce premier moyen d'étanchéification 10 peut être constitué par un caoutchouc butyl de la marque « Henkel »

Afin d'assurer une barrière d'étanchéité à l'eau liquide, on injecte par une technique d'extrusion ou d'injection, ou on rapporte par emboitage (« clipsage ») au sein de la gorge 9 un second moyen d'étanchéification 11. Ce second joint 11 est rapporté en même temps que le premier joint 10 ou postérieurement au passage dans l'autoclave

Le second moyen 11 d'étanchéification périphérique est formé d'un joint en polymère du type EPDM, en forme d'anneau avec par exemple un profil en O, constituant un joint torique.

Un exemple de réalisation de ce deuxième moyen d'étanchéification peut être constitué par un EPDM

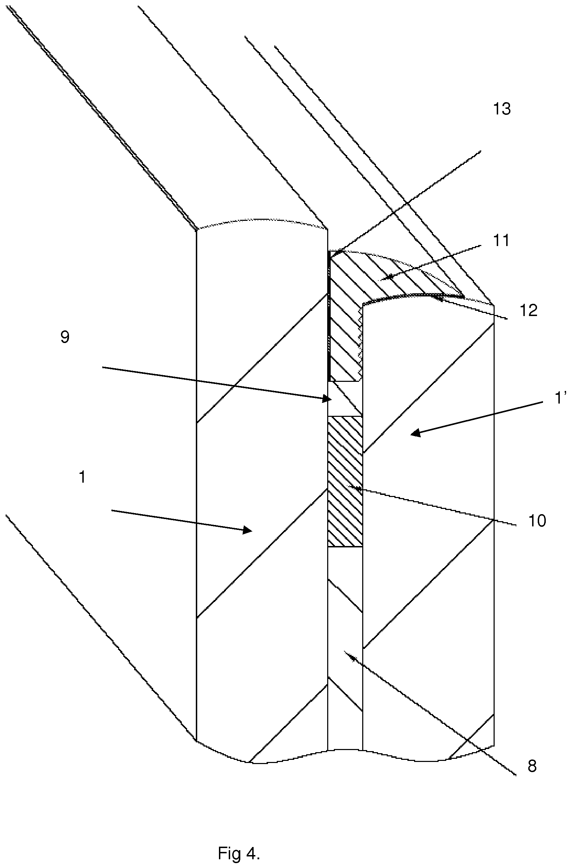

Selon un deuxième mode de réalisation (se reporter à la figure 3 ou la figure 4), le deuxième moyen 11 d'étanchéification est rapporté de manière affleurante dans la gorge 9 qui est formée lors de l'assemblage de deux substrats de dimensions différentes (l'un étant plus grand que l'autre). La gorge 9 forme une zone 12 en retrait ou un épaulement qui est comblé par la partie affleurante du joint. On peut ainsi protéger l'un des chants de l'un des substrats 1 ou 1' en conformant un pare-choc 13.

## Revendications

1. Procédé d'étanchéification d'un élément capable de collecter de la lumière, ledit élément comportant un premier substrat à fonction verrière (1) et un second substrat (1'), lesdits substrats emprisonnant à l'aide d'un intercalaire de feuilletage (8) un empilement (7) actif de couches comprenant des couches conductrices formant électrodes et au moins une couche fonctionnelle à base d'un matériau absorbeur permettant une conversion énergétique de la lumière en énergie électrique, ledit empilement étant déposé sur au moins une portion de surface de l'un au moins des substrats (1, 1') de manière à délimiter en périphérie une gorge (9) adaptée pour recevoir au moins un moyen d'étanchéification (10, 11) dudit élément, **caractérisé en ce qu'**on dépose le moyen d'étanchéification (10, 11) dans la gorge (9) avant la phase d'autoclave et après avoir ôté les bulles d'air emprisonnées au sein dudit élément.

2. Procédé d'étanchéification d'un élément capable de collecter de la lumière selon la revendication 1, **caractérisé en ce qu'**on dépose le moyen d'étanchéification (10, 11) avant une phase de pré-laminage.

3. Procédé selon l'une des revendications 1 ou 2, **caractérisé en ce que** la gorge (9) est remplie au moins en partie par un premier moyen d'étanchéification (10), notamment vis-à-vis de l'eau sous forme vapeur, le premier moyen d'étanchéification comprenant au moins un joint à base de polymère(s) thermofusible(s) choisi(s) parmi au moins une des familles de polymère suivantes : étylène-vinylacétate, polyisobutylène, butyle, polyamide, ou à base d'un mastic, notamment à base de polyuréthane, polysulfure ou silicone.

4. Procédé selon l'une quelconque des revendications précédentes, **caractérisé en ce que** le(s) joint(s) du premier moyen d'étanchéification (10) périphérique présente(nt) une viscosité comprise entre 0,1 et 20 Pa.s, notamment comprise entre 0,8 et 15 Pa.s, à 190°C.

5. Procédé selon l'une quelconque des revendications précédentes, **caractérisé en ce que** le(s) joint(s) du premier moyen d'étanchéification (10) périphérique présente(nt) un point de ramollissement compris entre 150 et 250°C, et préférentiellement compris entre 180 et 220°C.

6. Procédé selon l'une quelconque des revendications précédentes, **caractérisé en ce que** le(s) joint(s) du premier moyen d'étanchéification (10) périphérique présente(nt) une perméabilité à l'eau sous forme vapeur inférieure ou égale à 1 g/m²/24h, préférentiellement inférieure à 0.5 g/m²/24h, de manière encore plus préférée inférieure à 0.26 g/m²/24h selon la norme ASTM E 9663 T.

7. Procédé selon l'une quelconque des revendications précédentes, **caractérisé en ce que** le(s) joint(s) du premier moyen d'étanchéification (10) périphérique est (sont) posé(s) par extrusion ou injection en phase liquide.

8. Procédé selon l'une quelconque des revendications précédentes, **caractérisé en ce que** le(s) joint(s) du premier moyen d'étanchéification (10) périphérique présente(nt) une température d'extrusion ou d'injection supérieure à la température de fusion de l'intercalaire de feuilletage (8).

9. Procédé selon la revendication 1 ou la revendication 2, **caractérisé en ce qu'**on rapporte après la phase d'autoclave un second moyen d'étanchéification (11) périphérique, sous forme d'au moins un joint étanche vis-à-vis de l'eau liquide, notamment choisi à base de polyuréthane, de silicone, de polysulfure.

10. Procédé selon la revendication 1 ou la revendication 2, **caractérisé en ce qu'**on rapporte avant la phase d'autoclave un second moyen d'étanchéification (11) périphérique, sous forme d'au moins un joint étanche vis-à-vis de l'eau liquide, notamment choisi à base de polyuréthane, de silicone, de polysulfure

11. Procédé selon la revendication 9 ou 10, **caractérisé en ce que** le second moyen d'étanchéification (11) périphérique est formé d'un joint en polymère du type EPDM.

12. Procédé selon l'une des revendications 9 à 11, **caractérisé en ce que** le second moyen d'étanchéification (11) périphérique se présente sous la forme d'un anneau.

13. Procédé selon l'une des revendications 9 à 12, **caractérisé en ce que** le second moyen d'étanchéification (11) est rapporté par collage, par emboitage au sein de ladite gorge (9).

14. Procédé selon l'une des revendications 9 à 13, **caractérisé en ce que** le second moyen d'étanchéification (11) est rapporté de manière affleurante au sein d'une zone (12) en retrait périphérique, cette zone étant venue lors de l'assemblage de deux substrats, l'un étant de dimension inférieure à l'autre.

## Patentansprüche

1. Verfahren zum Abdichten eines Elements zum Sammeln von Licht, wobei das Element ein erstes Substrat (1) mit einer Glasfunktion und ein zweites Substrat (1') umfasst, wobei die Substrate mithilfe einer Laminationszwischenschicht (8) einen aktiven Schichtstapel mit Elektrode-bildenden leitfähigen Schichten und wenigstens einer funktionellen Schicht auf Basis eines Absorbermaterials zum Umwandeln von Lichtenergie in elektrische Energie einschließen, wobei der Stapel auf wenigstens einem Oberflächenabschnitt wenigstens eines der Substrate (1, 1') abgeschieden ist, und im Randbereich eine Nut (9) definiert, die wenigstens ein Dichtmittel (10, 11) zum Abdichten des Elements aufnehmen kann, **dadurch gekennzeichnet, dass** das Dichtmittel (10, 11) vor der Autoklavierphase und nachdem die im Element eingefangenen Luftblasen entfernt wurden, in die Nut (9) eingebracht wird.

2. Verfahren zum Abdichten eines Elements zum Sammeln von Licht wie in Anspruch 1 beansprucht, **dadurch gekennzeichnet, dass** das Dichtmittel (10, 11) vor einer Prälaminationsphase eingebracht wird.

3. Verfahren wie in einem der Ansprüche 1 oder 2 beansprucht, **dadurch gekennzeichnet, dass** die Nut (9) wenigstens teilweise mit einem ersten Dichtmittel (10) gefüllt ist, insbesondere zur Abdichtung gegen Wasser in Dampfform, wobei das erste Dichtmittel wenigstens eine Dichtung basierend auf einem oder mehreren Thermoplasten, gewählt aus wenigstens einer der folgenden Polymerfamilien: Ethylen/Vinyl-Acetat, Polyisobutylen, Butyl, Polyamid, oder basierend auf einem Mastix, insbesondere basierend auf Polyurethan, Polysulfid oder Silikon, umfasst.

4. Verfahren wie in einem der vorhergehenden Ansprüche beansprucht, **dadurch gekennzeichnet, dass** die Dichtung(en) des ersten peripheren Dichtmittels (10) eine Viskosität zwischen 0,1 und 20 Pa·s, insbesondere zwischen 0,8 und 15 Pa·s, bei 190°C hat (haben).

5. Verfahren wie in einem der vorhergehenden Ansprüche beansprucht, **dadurch gekennzeichnet, dass** die Dichtung(en) des peripheren Dichtmittels (10) einen Erweichungspunkt zwischen 150 und 250 °C, und vorzugsweise zwischen 180 und 220 °C, hat (haben).

6. Verfahren wie in einem der vorhergehenden Ansprüche beansprucht, **dadurch gekennzeichnet, dass** die Dichtung(en) des peripheren Dichtmittels (10) eine Wasserdampfpermeabilität von gleich oder weniger als 1 g/m²/24 h, vorzugsweise weniger als 0,5 g/m²/24 h, stärker bevorzugt weniger als 0,26 g/m²/24 h, gemäß der Norm ASTM E 9663 T hat (haben).

7. Verfahren wie in einem der vorhergehenden Ansprüche beansprucht, **dadurch gekennzeichnet, dass** die Dichtung(en) des peripheren Dichtmittels (10) durch Extrusion oder Injektion in der Flüssigphase eingebracht wird (werden).

8. Verfahren wie in einem der vorhergehenden Ansprüche beansprucht, **dadurch gekennzeichnet, dass** die Dichtung(en) des peripheren Dichtmittels (10) eine Extrusions- oder Injektionstemperatur oberhalb dem Schmelzpunkt der Laminationszwischenschicht (8) hat (haben).

9. Verfahren wie in Anspruch 1 oder Anspruch 2 beansprucht, **dadurch gekennzeichnet, dass**, nach der Autoklavierphase, ein zweites peripheres Dichtmittel (11) in Form wenigstens einer Dichtung, die undurchlässig für flüssiges Wasser ist, insbesondere gewählt auf Basis von Polyurethan, Silikon oder Polysulfid, angebracht wird.

10. Verfahren wie in Anspruch 1 oder Anspruch 2 beansprucht, **dadurch gekennzeichnet, dass**, vor der Autoklavierphase, ein zweites peripheres Dichtmittel (11) in Form wenigstens einer Dichtung, die undurchlässig für flüssiges Wasser ist, insbesondere gewählt auf Basis von Polyurethan, Silikon oder Polysulfid, angebracht wird.

11. Verfahren wie in Anspruch 9 oder 10 beansprucht, **dadurch gekennzeichnet, dass** das zweite periphere Dichtmittel (11) durch eine Dichtung bestehend aus einem Polymer vom EPDM-Typ gebildet wird.

12. Verfahren wie in einem der Ansprüche 9 bis 11 beansprucht, **dadurch gekennzeichnet, dass** das zweite periphere Dichtmittel (11) die Form eines Rings annimmt.

13. Verfahren wie in einem der Ansprüche 9 bis 12 beansprucht, **dadurch gekennzeichnet, dass** das zweite periphere Dichtmittel (11) durch adhäsives Anhaften oder durch Einpassen in die Nut (9) angebracht wird.

14. Verfahren wie in einem der Ansprüche 9 bis 13 beansprucht, **dadurch gekennzeichnet, dass** das zweite periphere Dichtmittel (11) so angebracht wird, dass es bündig mit einem peripheren Rückversatz-Bereich (12) ist, wobei dieser Bereich während des Fügens von zwei Substraten, von denen eines kleinere Abmessungen hat als das andere, gebildet wird.

## Claims

1. Method of sealing an element capable of collecting light, said element comprising a first substrate (1) having a glass function and a second substrate (1'), said substrates sandwiching, with the aid of a lamination interlayer (8), an active stack (7) of layers comprising electrode-forming conductive layers and at least one functional layer based on an absorber material for converting light energy into electrical energy, said stack being deposited on at least one surface portion of at least one of the substrates (1, 1') so as to define, on the periphery, a groove (9) suitable for accommodating at least one sealing means (10, 11) for sealing said element, **characterized in that** the sealing means (10, 11) is deposited in the groove (9) before the autoclaving phase and after having removed the air bubbles trapped within said element.

2. Method of sealing an element capable of collecting light as claimed in claim 1, **characterized in that** the sealing means (10, 11) is deposited before a pre-lamination phase.

3. Method as claimed in one of claims 1 or 2, **characterized in that** the groove (9) is at least partly filled with a first sealing means (10), especially against water in vapor form, the first sealing means comprising at least one seal based on one or more thermoplastics chosen from at least one of the following polymer families: ethylene/vinyl acetate, polyisobutylene, butyl, polyamide, or based on a mastic, especially based on polyurethane, polysulfide or silicone.

4. Method as claimed in any one of the preceding claims, **characterized in that** the seal(s) of the first peripheral sealing means (10) has (have) a viscosity between 0.1 and 20 Pa·s, especially between 0.8 and 15 Pa·s, at 190°C.

5. Method as claimed in any one of the preceding claims, **characterized in that** the seal(s) of the first peripheral sealing means (10) has (have) a softening point between 150 and 250°C, and preferably between 180 and 220°C.

6. Method as claimed in any one of the preceding claims, **characterized in that** the seal(s) of the first peripheral sealing means (10) has (have) a water vapor permeability equal to or less than 1 g/m²/24 h, preferably less than 0.5 g/m²/24 h, more preferably less than 0.26 g/m²/24 h according to the ASTM E 9663 T standard.

7. Method as claimed in any one of the preceding claims, **characterized in that** the seal(s) of the first peripheral sealing means (10) is (are) deposited by extrusion or injection in liquid phase.

8. Method as claimed in any one of the preceding claims, **characterized in that** the seal(s) of the first peripheral sealing means (10) has (have) an extrusion or injection temperature above the melting point of the lamination interlayer (8).

9. Method as claimed in claim 1 or claim 2, **characterized in that**, after the autoclaving phase, a second peripheral sealing means (11), in the form of at least one seal impervious to liquid water, especially one chosen based on polyurethane, silicone or polysulfide, is attached.

10. Method as claimed in claim 1 or claim 2, **characterized in that**, before the autoclaving phase, a second peripheral sealing means (11), in the form of at least one seal impervious to liquid water, especially one chosen based on polyurethane, silicone or polysulfide, is attached.

11. Method as claimed in claim 9 or 10, **characterized in that** the second peripheral sealing means (11) is formed by a seal made of a polymer of the EPDM type.

12. Method as claimed in any one of claims 9 to 11, **characterized in that** the second peripheral sealing means (11) takes the form of a ring.

13. Method as claimed in any one of claims 9 to 12, **characterized in that** the second sealing means (11) is attached by adhesive bonding or by fitting into said groove (9).

14. Method as claimed in any one of claims 9 to 13, **characterized in that** the second sealing means (11) is attached so as to be flush within a peripheral set-back region (12), this region being formed during assembly of two substrates, one being of smaller dimensions than the other.
